# EUROPÄISCHE PATENTSCHRIFT

(11) **EP 0 574 785 B1**
(45) Veröffentlichungstag und Bekanntmachung des Hinweises auf die Patenterteilung: **22.05.1996**
(21) Anmeldenummer: 93109115.1
(22) Anmeldetag: 07.06.1993
(51) Int. Cl.: C23C 14/08, C04B 35/44, C01F 17/00, G02B 1/00

(54) **Verfahren zur Herstellung von Aufdampfmaterial für die Herstellung mittelbrechender optischer Schichten**
Process for producing evaporation material for preparation of medium refractive index optical films
Procédé de fabrication de matériau à vaporiser pour la production de films optique à indice de réfraction moyen

(30) Priorität: 17.06.1992 DE 4219817
(43) Veröffentlichungstag der Anmeldung: 22.12.1993
(73) Patentinhaber: MERCK PATENT GmbH, D-64271 Darmstadt (DE)
(72) Erfinder: Friz, Martin, Dr., W-6109 Mühltal 4 (DE)

(56) Entgegenhaltungen:
- JOURNAL OF THE AMERICAN CERAMIC SOCIETY Bd. 74, Nr. 2, Februar 1991, COLUMBUS US Seiten 437 - 439 GUN YONG SUNG ET AL. 'Synthesis and preparation of Lanthanum Aluminate Target for Radio Frequency Magnetron Sputtering'
- CHEMICAL ABSTRACTS, vol. 73 Columbus, Ohio, US; abstract no. 82298, TKACHUK, A. M. ET AL. 'Interactions of chromium ions in lanthanum aluminate crystals' *
- JOURNAL OF THE AMERICAN CERAMIC SOCIETY Bd. 63, Nr. 7, Juli 1980, COLUMBUS US Seiten 416 - 419 ROPP ET AL. 'Solid State Kinetics of LaAl11O18' *
- CHEMICAL ABSTRACTS, vol. 97, no. 4, Juli 1982, Columbus, Ohio, US; abstract no. 32562d, KACSALOVA ET AL. 'Study of the Formation of Yttrium Aluminate (YAlO3 and Y3Al5O12)' *

## Beschreibung

Dünne Oxidschichten werden in der Technik, insbesondere in der Optik, in großem Umfang als Schutzschichten oder für optische Funktionszwecke verwendet. So können sie als Schutz gegen Korrosion und mechanische Beschädigung oder zur Vergütung der Oberflächen optischer Bauteile und Instrumente, wie insbesondere Linsen, Spiegel, Prismen etc. dienen. Weiterhin werden dünne Oxidschichten zur Herstellung hoch-, mittel- und niedrigbrechender optischer Schichten zur Reflexionserhöhung oder -erniedrigung gebraucht. Hauptanwendungsgebiete sind die Herstellung von Antireflex- und Vergütungsschichten auf Brillengläsern sowie auf Linsen für Kameraobjektive, Ferngläser und optische Bauteile für optische Meßinstrumente und für die Lasertechnik. Weiterhin sind dies die Herstellung von Schichten mit bestimmtem Brechungsindex und/oder bestimmten optischen Absorptionseigenschaften, beispielsweise bei Interferenzspiegeln, Strahlenteilern, Wärmefiltern und Kaltlichtspiegeln.

Ausgangsmaterialien zur Herstellung derartiger Oxidschichten sind an sich bekannt. Üblich sind SiO₂ sowie eine Vielfalt von Metalloxiden, gegebenenfalls in Kombination miteinander. Die Auswahl erfolgt im wesentlichen empirisch nach Maßgabe der angestrebten optischen Eigenschaften und der Verarbeitbarkeit. Die Herstellung der Schichten erfolgt nach der an sich bekannten Vakuum-Aufdampftechnik. Zur beispielhaften Illustration sei hier die DE-PS 12 28 489 sowie H.A.Macleod "Thin Film Optical Filters", A. Hilger Ltd., Bristol 1986, zitiert, aus der sich Hinweise zu verwendbaren Materialien und zur Verarbeitungstechnik sowie zu den in dem Zusammenhang stehenden Problematiken entnehmen lassen.

Für die Herstellung von mittelbrechenden Schichten, also Schichten, die optische Brechungsindex-Werte zwischen 1,6 und 1,9 aufweisen, ist die Auswahl an prinzipiell geeigneten Ausgangsstoffen begrenzt. Als Ausgangsmaterialien kommen im wesentlichen die Oxide von Aluminium, Magnesium, Yttrium, Lanthan, Praseodym, auch Cerfluorid und Lanthanfluorid sowie Mischsysteme hiervon in Frage. Bevorzugtes Ausgangsmaterial für mittelbrechende Schichten ist Aluminiumoxid.

Diese an sich geeigneten Materialien haben jedoch eine Reihe von Nachteilen, die sich insbesondere in verarbeitungspraktischer Hinsicht bemerkbar machen.

Ein Gesichtspunkt hierbei ist, daß diese Substanzen hohe Schmelz- und Siedepunkte haben, die außerdem relativ nahe beieinander liegen. Aus praktischer Hinsicht ist es aber wichtig, daß die Aufdampfmaterialien vor dem Beginn einer merklichen Abdampfung vollständig eingeschmolzen sind. Nur dann ist eine gleichmäßige und ausreichende Abdampfrate gewährleistet. Diese ist erforderlich, damit sich auf den zu bedampfenden Objekten homogene und gleichmäßig dicke Schichten ausbilden. Bei den Oxiden von Magnesium und Yttrium ist dies aber unter praktischen Anwendungsbedingungen nicht der Fall. Die genannten Substanzen schmelzen unter den üblichen Arbeitsbedingungen nicht bzw. nicht vollständig ein. Sie sind insgesamt schwierig zu verdampfen und man erhält Schichten mit Schichtdicken-Schwankungen.

Magnesiumoxid bildet immer poröse Schichten, in die leicht Feuchtigkeit eingelagert wird, wodurch die Schicht instabil wird. Gleiches gilt auch für Lanthanoxid. Cerfluorid und Lanthanfluorid bilden ebenfalls inhomogene Schichten mit nicht ausreichender Härte und Haltbarkeit.

Man ist daher bestrebt, durch geeignete Zusätze die Schmelzpunkte der Grundmaterialien herabzusetzen. Zusätze dienen weiterhin dazu, dem Brechungsindex in der erhaltenen Schicht in bestimmten Grenzen zu variieren und gezielt einzustellen.

Die Auswahl an geeigneten Zusätzen für diese Zwecke ist durch die Forderung nach Absorptionsfreiheit eingeschränkt. Es kommen daher nur solche Metalloxide als entsprechende Zusätze in Frage, die im nahen infraroten und im sichtbaren Spektralbereich bis in den nahen UV-Wellenlängenbereich (ca. bis 200 nm) keine Absorptionen haben.

Titandioxid, Praseodymoxid und Neodymoxid beispielsweise sind aus diesem Grund ungünstig.

Obwohl sich durch geeignete Wahl an Zusatzstoffen bzw. die Auswahl entsprechender Stoffgemische die vorgenannten Probleme lösen lassen, ist der Einsatz von Mischsystemen an sich in der Vakuum-Aufdampftechnik nicht zu bevorzugen. Der Grund ist der, daß Mischsysteme in der Regel inkongruent verdampfen, d.h. sie verändern im Verlaufe des Verdampfungsprozesses ihre Zusammensetzung und entsprechend verändert sich auch die Zusammensetzung der abgeschiedenen Schichten und somit deren Brechungsindex. Typisches Beispiele hierfür sind Tantaloxid-Aluminiumoxid- bzw. Hafniumoxid-Aluminiumoxid-Mischsysteme.

Der Erfindung lag nun die Aufgabe zugrunde, ein Aufdampfmaterial zur Herstellung mittelbrechender optischer Schichten nach der Vakuumaufdampftechnik zu finden, das die Nachteile der bekannten Materialien nicht aufweist und mit dem sich insbesondere gleichmäßige, homogen zusammengesetzte und im sichtbaren Bereich absorptionsfreie Schichten herstellen lassen.

Vorüberlegungen ließen ein System auf Basis der Cxide von Lanthan und Aluminium als diesbezüglich interessant erscheinen.

Allerdings erwiesen sich Gemische dieser Oxide als für die praktische Handhabung ungeeeignet, da diese Feuchtigkeit aufnehmen und durch irreversible Umwandlung in Hydroxid für die Vakuumverdampfung unbrauchbar werden.

Überraschend wurde aber nun gefunden, daß sich Verbindungen der Formel La₁₋ₓAl₁₊ₓO₃ mit x = 0 bis 0,84 hervorragend als Aufdampfmaterial zur Herstellung mittelbrechender optischer Schichten durch Vakuumverdampfung eignen. Es hat sich gezeigt, daß diese Materialien sich problemlos und ohne Spritzen im Vakuum verdampfen lassen und unter den in der Vakuumverdampfungstechnik üblichen Arbeitsbedingungen ohne weiteres zu homogenen, absorptionsfreien, stabilen Schichten führen.

Als besonders bevorzugtes Aufdampfmaterial ist eine Verbindung anzusehen, die sich durch die Formel La₁₋ₓAl₁₋ₓO₃ mit x = 0 bis 0,6 charakterisieren läßt.

Gegenstand der Erfindung ist ein Verfahren gemäß Anspruch 1 zur Herstellung eines derartigen Aufdampfmaterials, sowie die Verwendung gemäß Anspruch 2 von Aufdampfmaterialen hergestellt nach dem Verfahren gemäß Anspruch 1 zur Herstellung von optischen Schichten.

Gegenstand der Erfindung ist weitherhin ein Verfahren gemäß Anspruch 3 zur Herstellung von hochbrechenden optischen Schichten, bei dem man Substrate im Vakuum mit einem derartigen Aufdampfmaterial bedampft.

Bei dem erfindungsgemäßen Aufdampfmaterial handelt es sich nicht um Gemische der beiden Oxide sondern um Mischoxidverbindungen mit diskreter, stöchiometrisch definierter Zusammensetzung. In diesen Verbindungen können Lanthanoxid und Aluminiumoxid im Molverhältnis 1:1 bis 1:11, vorzugsweise 1:1 bis 1:5, vorliegen. In allen diesen Mischoxidverbindungen ist der Sauerstoffgehalt exakt stöchiometrisch.

Bei diesen Materialien tritt während der Vakuumverdampfung keine Abgabe von Sauerstoff auf. Der gewählte Zusammensetzungsbereich liegt so, daß sich unter den üblichen Arbeitsbedingungen bei der Vakuumverdampfungstechnik ohne weiteres absorptionsfreie Schichten bilden. Hierbei zeigte es sich außerdem, daß die optischen Eigenschaften der erhaltenen Schichten kaum durch Schwankungen des Sauerstoffrestdrucks während der Vakuumverdampfung beeinflußt werden.

Diese Befunde sind im besonderen Maße überraschend und nicht vorhersehbar.

Die Aufdampfmaterialien lassen sich in der Weise erhalten, daß man die Oxide von Lanthan und Aluminium im entsprechenden stöchiometrischen Verhältnis mischt und im Hochvakuum unterhalb der Schmelztemperatur sintert. Ein derartiges Herstellverfahren gemäß Anspruch 1 für die Aufdampfmaterialien ist Gegenstand der Erfindung. Das gesinterte Produkt liegt in Form harter, weißer Körner vor, schmilzt ab einer Temperatur von ca. 1800 °C vollständig ein und läßt sich in einem Vakuum von ca. 10⁻⁴ mbar bei Temperaturen zwischen 2200 und 2300 °C verdampfen.

Das Aufdampfmaterial kann in den in der einschlägigen Technik üblichen Vakuum-Aufdampfapparaturen bzw. -Anlagen in bekannter Weise und unter den hierfür gängigen Verarbeitungsbedingungen eingesetzt werden. Die Vakuumverdampfung kann nicht nur durch thermische Verdampfung sondern auch durch Elektronenstrahl-Verdampfung vorgenommen werden.

Mit dem Material können auf beliebigen geeigneten Substraten homogene dünne Schichten gleichmäßiger Schichtdicke erzeugt werden, die haftfest und in besonderem Maße gegen mechanische und chemische Einflüsse resistent sind. Die Schichten sind mittelberechend; ihr Brechungsindex liegt, je nach Zusammensetzung und in Abhängigkeit von der Wellenlänge bei der gemessen wird, bei Werten zwischen 1,6 und 1,9. Die Schichten haben eine hohe Transmission in einem Wellenlängenbereich vom nahen UV (ab etwa 200 nm) über den sichtbaren Bereich bis in das nahe IR (ca. 7000 nm) und sind insbesondere im sichtbaren Wellenlängenbereich frei von Absorptionen.

### Beispiel 1: Herstellung

Es wird aus
51 Gew.% Lanthan(III)oxid
49 Gew.% Aluminium(III)oxid ein Pulvergemisch hergestellt und dieses granuliert. Die Zusammensetzung ist so gewählt, daß sich eine Verbindung der Formel La_{0,5}Al_{1,5}O₃ bildet.

Das Granulat wird im Hochvakuum (10⁻⁴ mbar) bei einer Temperatur von 1600 bis 1680 °C 3 bis 8 Stunden gesintert. Das erhaltene weiße Produkt hat einen Schmelzpunkt von 1930 °C.

### Beispiel 2: Herstellung

Es wird aus
76 Gew.% Lanthan(III)oxid
24 Gew.% Aluminium(III)oxid ein Pulvergemisch hergestellt und dieses granuliert. Die Zusammensetzung ist so gewählt, daß sich eine Verbindung der Formel LaAlO₃ bildet.

Das Granulat wird im Hochvakuum (10⁻⁴ mbar) bei einer Temperatur von 1600 bis 1680 °C 3 bis 8 Stunden gesintert. Das erhaltene weiße Produkt hat einen Schmelzpunkt von 1850 °C.

### Beispiel 3: Anwendung

Das Granulat von Beispiel 1 wird in einen Verdampfungstiegel aus Kupfer gefüllt und in eine handelsübliche Vakuumaufdampfapparatur mit Elektronenstrahl-Verdampfung verbracht.

Das zu bedampfende Substrat besteht aus Quarz oder Glas.

Die Beschichtung erfolgt bei einer Temperatur von 2200 bis 2300 °C und einem O₂-Restdruck von 2 × 10⁻⁴ mbar bei einer Substrattemperatur von 250 °C und mit einer Abscheidungsrate von 0,4 nm/sec bis eine Schichtdicke von 250 nm erreicht ist.

Die Schicht hat einen Brechungsindex bei 500 nm von n = 1,7. Die Schicht zeigt keine Absorption im sichtbaren Bereich und bis zu einer Wellenlänge von ca. 200 nm.

Die analoge Verarbeitung des Granulats von Beispiel 2 liefert eine Schicht mit einem Brechungsindex bei 500 nm von n = 1,8.

## Patentansprüche

1. Verfahren zur Herstellung von Aufdampfmaterialien der chemischen Zusammensetzung La₁₋ₓAl₁₊ₓO₃ mit x = 0 bis 0,84, vorzugsweise 0 bis 0,6, dadurch gekennzeichnet, daß man Oxide von Lanthan und Aluminium im Molverhältnis 1 : 1 bis 1 : 11 mischt und im Hochvakuum unterhalb der Schmelztemperatur sintert.

2. Verwendung von Aufdampfmaterialien hergestellt nach dem Verfahren gemäß Anspruch 1 mit der chemischen Zusammensetzung La₁₋ₓAl₁₊ₓO₃ mit x = 0 bis 0,84, vorzugsweise 0 bis 0,6, zur Herstellung von mittelbrechenden optischen Schichten mit Brechungsindex-Werten zwischen 1,6 und 1,9 auf optischen Substraten durch Bedampfen im Vakuum.

3. Verfahren zur Herstellung von mittelbrechenden optischen Schichten mit Brechungsindex-Werten zwischen 1,6 und 1,9 durch Bedampfen von optischen Substraten im Vakuum, dadurch gekennzeichnet, daß man mit Aufdampfmaterialien hergestellt nach dem Verfahren gemäß Anspruch 1 mit der chemischen Zusammensetzung La₁₋ₓAl₁₊ₓO₃ mit x = 0 bis 0,84, vorzugsweise 0 bis 0,6, bedampft.

## Revendications

1. Procédé de préparation de matières à vaporiser de composition chimique La₁₋ₓAl₁₊ₓO₃ dans lesquelles x = 0 à 0,84, de préférence 0 à 0,6, caractérisé en ce qu'on mélange des oxydes de lanthane et d'aluminium dans un rapport molaire de 1:1 à 1:11 et en ce qu'on fritte sous un vide poussé en-dessous de la température de fusion.

2. Application de matières à vaporiser préparées selon le procédé de la revendication 1 de composition chimique La₁₋ₓAl₁₊ₓO₃ dans lesquelles x = 0 à 0,84, de préférence 0 à 0, 6, à la préparation de couches optiques à pouvoir de réfraction moyen avec des valeurs d'indice de réfraction comprises entre 1,6 et 1,9 sur des substrats optiques par vaporisation sous vide.

3. Procédé de préparation de couches optiques à pouvoir de réfraction moyen ayant des valeurs d'indice de réfraction comprises entre 1,6 et 1,9 par vaporisation de substrats optiques sous vide, caractérisé en ce qu'on vaporise avec des matières à vaporiser préparées selon le procédé de la revendication 1 de composition chimique La₁₋ₓAl₁₊ₓO₃ dans lesquelles x = 0 à 0,84, de préférence 0 à 0,6.

## Claims

1. Process for the preparation of vapour-deposition materials having the chemical composition La₁₋ₓAl₁₊ₓO₃, where x = 0 to 0.84, preferably 0 to 0.6, characterized in that oxides of lanthanum and aluminium are mixed in a molar ratio of from 1:1 to 1:11 and are sintered in a high vacuum at below the melting point.

2. Use of vapour-deposition materials prepared by the process according to Claim 1, having the chemical composition La₁₋ₓAl₁₊ₓO₃, where x = 0 to 0.84, preferably 0 to 0.6, for the production of optical coatings of medium refractive index, having refractive index values of between 1.6 and 1.9, on optical substrates by vacuum vapour deposition.

3. Process for the production of optical coatings of medium refractive index, having refractive index values of between 1.6 and 1.9, by vacuum vapour deposition on optical substrates, characterized in that the vapour deposition is carried out using vapour-deposition materials prepared by the process according to Claim 1, having the chemical composition La₁₋ₓAl₁₊ₓO₃, where x = 0 to 0.84, preferably 0 to 0.6.
